# EUROPÄISCHE PATENTSCHRIFT

(11) **EP 2 183 779 B1**
(45) Veröffentlichungstag und Bekanntmachung des Hinweises auf die Patenterteilung: **27.03.2019**
(21) Anmeldenummer: 08801256.2
(22) Anmeldetag: 29.08.2008
(51) Int. Cl.: H01L 25/075

(54) **HALBLEITERBAUELEMENT**
SEMICONDUCTOR COMPONENT
COMPOSANT SEMI-CONDUCTEUR

(30) Priorität: 04.09.2007 DE 102007041896
(43) Veröffentlichungstag der Anmeldung: 12.05.2010
(73) Patentinhaber: OSRAM Opto Semiconductors GmbH, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/DE2008/001449
(87) Internationale Veröffentlichungsnummer: WO 2009/030204

(56) Entgegenhaltungen:
- EP-A- 1 947 693
- WO-A-2005/099310
- WO-A-2006/054236
- DE-A1-102004 039 897
- US-A1- 2003 025 657
- US-A1- 2005 253 252
- US-A1- 2006 002 142
- US-A1- 2006 076 566

## Beschreibung

Die vorliegende Anmeldung betrifft ein Halbleiterbauelement aufweisend wenigstens einen optisch aktiven ersten Bereich zum Abstrahlen von elektromagnetischer Strahlung in wenigstens eine Abstrahlrichtung und wenigstens einen optisch aktiven zweiten Bereich zum Abstrahlen von elektromagnetischer Strahlung in die wenigstens eine Abstrahlrichtung. Halbleiterbauelemente mit optisch aktiven Bereichen sind vielfach bekannt und werden in einer Vielzahl von Anwendungen eingesetzt. Insbesondere ist es bekannt, Halbleiterdiodenstrukturen als Strahlungsquelle zu verwenden. Um leistungsstarke und zugleich flächige Strahlungsquellen zu ermöglichen, ist es bekannt, mehrere optisch aktive Bereiche in einem gemeinsamen Gehäuse oder auf einem gemeinsamen Substrat anzuordnen. Beispielsweise ist aus der WO 2006/012442 A2 ein optoelektronisches Bauelement mit einem Gehäusekörper bekannt, bei dem eine Mehrzahl von Halbleiterchips in einer linienförmigen Anordnung angeordnet ist. Dabei weisen benachbarte Halbleiterchips zueinander einen Abstand auf.

Die Druckschriften WO2005/099310 A, DE 10 2004 039897 und US 2003/025657 A1 beschreiben Halbleiterbauelemente und Verfahren zur Herstellung von Halbleiterbauelementen.

Eine Aufgabe der Erfindung ist es, ein Halbleiterbauelement zu beschreiben, das eine hohe optische Ausgangsleistung bereitstellt. Dabei soll das Bauelement eine hohe Packungsdichte oder Strahlungsdichte aufweisen. Des Weiteren soll ein Herstellungsverfahren für ein derartiges Halbleiterbauelement angegeben werden.

Diese Aufgabe wird durch ein Halbleiterbauelement gemäß dem unabhängigen Patentanspruch gelöst. Ausgestaltungen und weiterbildungen des Halbleiterbauelements sind in den abhängigen Ansprüchen angegeben. Der Offenbarungsgehalt der Patentansprüche wird hiermit explizit durch Rückbezug in die Beschreibung aufgenommen.

Die zugrunde liegende Aufgabe wird durch ein Halbleiterbauelement der oben genannten Art gelöst, das dadurch gekennzeichnet ist, dass der erste Bereich in einer ersten Schicht und der zweite Bereich in einer zweiten Schicht angeordnet ist, wobei die zweite Schicht in der Abstrahlungsrichtung über der ersten Schicht angeordnet ist und einen dem ersten Bereich zugeordneten ersten Durchlassbereich aufweist, der zumindest teilweise durchlässig für die elektromagnetische Strahlung des ersten Bereichs ist, wobei zwischen der ersten und der zweiten Schicht wenigstens eine Schicht aus einem metallischen Material angeordnet ist, die wenigstens eine Aussparung in einem dem ersten Bereich zugeordneten zweiten Durchlassbereich aufweist. Insbesondere wird unter der Abstrahlungsrichtung die Richtung einer Flächennormalen einer Haupterstreckungsebene des ersten und/oder zweiten Bereichs verstanden.

Durch das Überaneinanderanordnen einer ersten Schicht mit einem ersten optisch aktiven Bereich und einer zweiten Schicht mit einem zweiten optisch aktiven Bereich und einem Durchlassbereich wird die effektiv zur Abstrahlung von elektromagnetischer Strahlung verwendete Fläche vergrößert, ohne die einzelnen optisch aktiven Bereiche zu vergrößern.

Die zweite Schicht weist in dem ersten Durchlassbereich wenigstens eine Aussparung zum Durchlassen der elektromagnetischen Strahlung der ersten Schicht auf. Die Aussparung in dem Durchlassbereich ermöglicht eine ungehinderte Ausstrahlung der elektromagnetischen Strahlung der ersten Schicht durch die zweite Schicht.

Gemäß einer nicht beanspruchten Ausgestaltung weist die zweite Schicht in dem ersten Durchlassbereich wenigstens ein lichtdurchlässiges Material, zum Beispiel ein transparentes oder semitransparentes Material zum Durchlassen der elektromagnetischen Strahlung der ersten Schicht auf. Durch Verwendung eines transparenten oder semitransparenten Materials durchdringt die elektromagnetische Strahlung der ersten Schicht die zweite Schicht zumindest teilweise. Bei dem transparenten oder semitransparenten Material kann es sich zum Beispiel um Indium-Zinn-Oxid (ITO) handeln.

Gemäß einer Ausgestaltung ist das metallische Material der zwischen der ersten und zweiten Schicht angeordneten weiteren Schicht zum Ableiten von Wärme aus der ersten und/oder zweiten Schicht, insbesondere aus dem ersten und/oder zweiten Bereich, eingerichtet. Alternativ oder zusätzlich kann es zur Herstellung wenigstens eines elektrischen Kontakts zu dem ersten und/oder zweiten Bereich dienen. Durch die Verwendung eines metallischen Materials in dem Halbleiterbauelement wird die thermische oder elektrische Kontaktierung der optischen aktiven Bereiche vereinfacht.

Gemäß einer weiteren vorteilhaften Ausgestaltung sind der erste Durchlassbereich und der zweite Bereich räumlich benachbart und bilden einen zusammenhängenden Abstrahlbereich. Durch eine benachbarte Anordnung des ersten Durchlassbereiches und des zweiten Bereiches der zweiten Schicht entsteht in Abstrahlrichtung der Eindruck einer flächigen Strahlungsquelle.

Gemäß einer weiteren Ausgestaltung sind die wenigstens erste und zweite Schicht in einem gemeinsamen Gehäusekörper angeordnet. Gemäß unterschiedlichen Ausgestaltungen ist der Gehäusekörper thermisch oder elektrisch mit der ersten und/oder der zweiten Schicht gekoppelt und dient als Wärmesenke zu dem ersten und/oder zweiten Bereich. Alternativ oder zusätzlich kann er als wenigstens ein Anschlusskontakt für den ersten und/oder zweiten Bereich dienen.

Gemäß einer weiteren Ausgestaltung umfasst der Gehäusekörper ein optisches Element, das von dem ersten und/oder zweiten Bereich ausgestrahlte elektromagnetische Strahlung in einer vorbestimmten Weise konvertiert, insbesondere durch Frequenzkonversion, Beugung, Brechung und/oder Filterung. Durch Kombination der optisch aktiven Bereiche mit einem optischen Element in einem gemeinsamen Gehäusekörper wird ein integriertes Bauteil mit vorbestimmten optischen Charakteristiken bereitgestellt.

Bei einer Weiterbildung ist der Gehäusekörper zumindest teilweise lichtdurchlässig, insbesondere zumindest teilweise transparent, ausgestaltet. Auf diese Weise dient der Gehäusekörper selbst als optisches Element.

Gemäß einer weiteren vorteilhaften Ausgestaltung weist der Gehäusekörper wenigstens einen ersten und einen zweiten Kontakt an einer Montagefläche auf und ist dazu eingerichtet mittels Oberflächenmontage auf einem Trägermaterial angeordnet zu werden. Die Verwendung zweier Kontakte an einer Montagefläche des Gehäusekörpers ermöglicht eine Oberflächenmontage des Halbleiterbauelementes.

Gemäß einer weiteren Ausgestaltung sind der erste und/oder der zweite Bereich als substratlose Halbleiterstrukturen ausgebildet. Durch Ausbildung der optisch aktiven Bereiche als substratlose Halbleiterstrukturen werden besonders dünne Schichten und somit besonders dünne Halbleiterbauelemente verwirklicht.

Eine substratlose Halbleiterstruktur ist insbesondere frei von einem Aufwachssubstrat. Vorliegend bedeutet "frei von einem Aufwachssubstrat", dass ein gegebenenfalls zum Aufwachsen benutztes Aufwachssubstrat von der Halbleiterstruktur entfernt oder zumindest stark gedünnt ist. Insbesondere ist es derart gedünnt, dass es für sich oder zusammen mit einer Epitaxie-Schichtenfolge der Halbleiterstruktur alleine nicht freitragend ist. Der verbleibende Rest des stark gedünnten Aufwachssubstrats ist insbesondere als solches für die Funktion eines Aufwachssubstrates ungeeignet.

Die substratlose Halbleiterstruktur weist insbesondere eine Dicke im Bereich von 20 um oder weniger, insbesondere im Bereich von 10 µm oder weniger auf.

Beispiele für substratlose Halbleiterstrukturen sind in der Druckschrift WO2008/014750 beschrieben, deren Offenbarungsgehalt insofern hiermit durch Rückbezug aufgenommen wird.

Gemäß einer weiteren Ausgestaltung ist zwischen der ersten und der zweiten Schicht wenigstens eine Kühlschicht zum Abführen von Wärme des ersten und/oder zweiten Bereiches angeordnet, die wenigstens in einem dem ersten Bereich zugeordneten zweiten Durchlassbereich teilweise transparent ausgebildet ist. Durch Anordnung einer zumindest teilweise transparenten Kühlschicht zwischen der ersten und der zweiten Schicht wird eine effektive Kühlung der optisch aktiven Bereiche ermöglicht.

Bei einer Weiterbildung dieser Ausgestaltung enthält die Kühlschicht einen Hohlraum, der wenigstens teilweise mit einer Kühlflüssigkeit gefüllt ist. Bei einer vorteilhaften Weiterbildung ist die Kühlflüssigkeit aktiv durch den Hohlraum gepumpt.

Gemäß einer weiteren vorteilhaften Ausgestaltung sind der erste Bereich zum Abstrahlen von elektromagnetischer Strahlung einer ersten Wellenlänge und der zweite Bereich zum Abstrahlen von elektromagnetischer Strahlung einer zweiten Wellenlänge ausgestaltet. Durch unterschiedliche Ausgestaltung des ersten und zweiten Bereiches zum Abstrahlen von elektromagnetischer Strahlung unterschiedlicher Wellenlänge wird die Abstrahlcharakteristik des Halbleiterbauelementes an vorgegebene Bedürfnisse angepasst. Beispielsweise ist es möglich, ein Bauelement zum Abstrahlen von Licht unterschiedlicher Farbe herzustellen.

Gemäß einer nicht beanspruchten Ausgestaltung sind der erste und der zweite Bereich in der Abstrahlrichtung übereinander angeordnet. Durch Übereinanderanordnen des ersten und des zweiten Bereiches in Abstrahlrichtung wird die Intensität oder spektrale Zusammensetzung der ausgesandten elektromagnetischen Strahlung durch Mischung an bestehende Bedürfnisse angepasst.

Gemäß einer weiteren vorteilhaften Ausgestaltung weist die erste und/oder zweite Schicht eine Mehrzahl von optisch aktiven Bereichen zum Abstrahlen von elektromagnetischer Strahlung auf, und jedem optisch aktiven Bereich der ersten Schicht ist ein Durchlassbereich der zweiten Schicht zugeordnet. Mittels einer Mehrzahl von optischen aktiven Bereichen in einer der Schichten wird die Abstrahlleistung des Halbleiterbauelementes weiter erhöht.

Gemäß einer weiteren vorteilhaften Ausgestaltung weist das Halbleiterbauelement eine Vielzahl von übereinander angeordneten Schichten mit jeweils wenigstem einem optisch aktiven Bereich zum Abstrahlen von elektromagnetischer Strahlung auf, wobei jede darüber liegende Schicht wenigstens einen Durchlassbereich für elektromagnetische Strahlung einer darunter liegenden Schicht aufweist. Durch das Übereinanderanordnen einer Mehrzahl von übereinander angeordneten Schichten mit jeweils einem optisch aktiven Bereich und einem dem darunter liegenden optisch aktiven Bereich zugeordneten Durchlassbereich wird die Abstrahlleistung des Halbleiterbauelementes weiter erhöht.

Das zur Erläuterung dienende Verfahren zur Herstellung eines Halbleiterbauelements umfasst die folgenden Schritte:
- Herstellen einer ersten Schicht mit wenigstens einem optischen aktiven ersten Bereich zum Abstrahlen von elektromagnetischer Strahlung in wenigstens einer Abstrahlrichtung,
- Anordnen der ersten Schicht in einem Gehäuse oder auf einem Trägermaterial,
- Herstellen einer zweiten Schicht mit wenigstens einem optisch aktiven zweiten Bereich zum Abstrahlen von elektromagnetischer Strahlung und wenigstens einem transparenten oder semitransparenten Durchlassbereich, und
- Anordnen der zweiten Schicht auf der ersten Schicht, wobei der Durchlassbereich der zweiten Schicht in Durchlassrichtung über dem ersten Bereich der ersten Schicht angeordnet wird, und wobei zwischen der ersten und der zweiten Schicht wenigstens eine Schicht aus einem metallischen Material angeordnet wird, die wenigstens eine Aussparung in einem dem ersten Bereich zugeordneten zweiten Durchlassbereich aufweist.

Weitere Vorteile und Einzelheiten der vorliegenden Erfindung sind in den Unteransprüchen angegeben. Die Erfindung wird nachfolgend anhand von Ausführungsbeispielen unter Bezugnahme auf die nachfolgenden, schematischen Figuren beschrieben, in denen gleiche Bezugszeichen für vergleichbare Merkmale der unterschiedlichen Ausführungsbeispiele verwendet werden.

In den Figuren zeigen:
- Figur 1: einen Querschnitt und eine Draufsicht eines Halbleiterbauelements mit zwei Schichten,
- Figur 2: eine Halbleiterdiodenstruktur zum Abstrahlen von elektromagnetischer Strahlung gemäß dem Stand der Technik,
- Figur 3: einen ersten Schichtstapel mit optisch aktiven Bereichen in verschiedenen Ebenen,
- Figur 4: einen zweiten Schichtstapel mit optisch aktiven Bereichen in verschiedenen Ebenen,
- Figur 5: einen Querschnitt und eine Draufsicht eines Halbleiterbauelements mit einer Mehrzahl von Schichten,
- Figur 6: eine Anordnung umfassend eine Mehrzahl von optisch aktiven Bereichen auf zwei Folien,
- Figur 7: ein Halbleiterbauelement mit einer ersten beispielhaften Kontaktierung,
- Figur 8: ein Halbleiterbauelement mit einer zweiten beispielhaften Kontaktierung,
- Figur 9: eine Anordnung mit mehreren übereinander angeordneten optisch aktiven Bereichen, und
- Figur 10: ein Ablaufdiagramm eines Verfahrens zum Herstellen eines Halbleiterbauelementes.

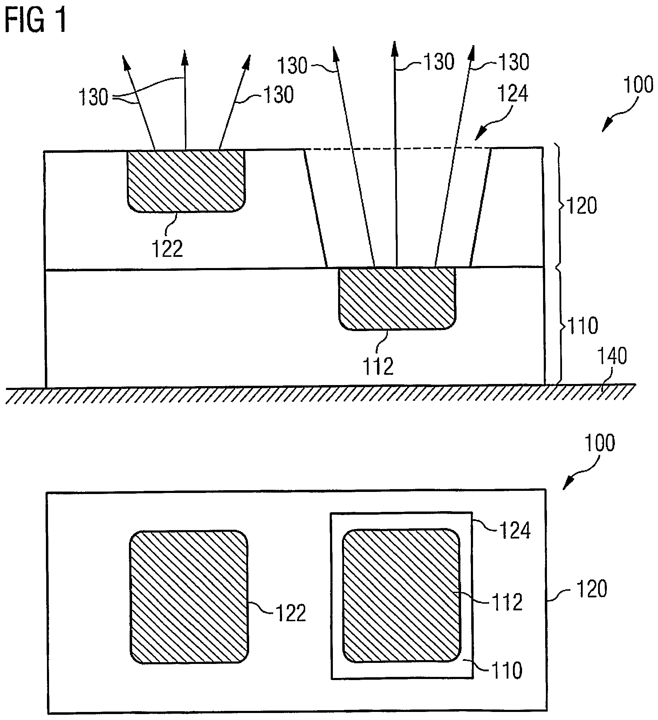

Figur 1 zeigt ein Halbleiterbauelement 100 gemäß einer Ausgestaltung der Erfindung. Der obere Teil der Figur 1 zeigt einen Querschnitt durch das Halbleiterbauelement 100. Der untere Teil der Figur 1 zeigt eine Draufsicht auf das Halbleiterbauelement 100.

Im Querschnitt ist zu erkennen, dass das Halbleiterbauelement 100 eine erste Schicht 110 und eine zweite Schicht 120 umfasst. In der ersten Schicht 110 ist ein erster optisch aktiver Bereich 112 angeordnet. Die zweite Schicht 120 umfasst einen zweiten optisch aktiven Bereich 122 sowie einen ersten Durchlassbereich 124. Die erste Schicht 110 ist auf einem Trägermaterial 140, beispielsweise einer Leiterplatte oder einem Halbleitersubstrat, angeordnet.

Der erste Durchlassbereich 124 der zweiten Schicht 120 ist über dem ersten optisch aktiven Bereich 112 der ersten Schicht 110 angeordnet. Wie aus der Figur 1 deutlich wird, strahlen sowohl der erste optisch aktive Bereich 112 als auch der zweite optisch aktive Bereich 122 elektromagnetische Strahlung 130 in eine gemeinsame Abstrahlrichtung ab, in dem in der Figur dargestellten Ausführungsbeispiel nach oben von dem Trägermaterial 140 weg.

Beispielsweise kann es sich bei der ersten Schicht 110 und der zweiten Schicht 120 um eine Schicht aus einem Halbleitersubstrat handeln. Das Halbleitersubstrat umfasst Diodenstrukturen, die durch Dotierung des Halbleitermaterials mit einer positiven beziehungsweise negativen Dotiersubstanz gebildet wurden und als erster und zweiter optisch aktiver Bereich 112 bzw. 122 wirken.

In der ebenfalls in der Figur 1 dargestellten Draufsicht ist die erste Schicht 110 des Halbleiterbauelementes 100 weitgehend durch dessen zweite Schicht 120 verdeckt. Dabei entsteht der Eindruck, als ob der erste optisch aktive Bereich 112 und der zweite optisch aktive Bereich 122 in derselben Ebene angeordnet wären. Mit anderen Worten wirkt das optisch aktive Bauelement 100 wie ein Bauelement mit zwei optisch aktiven Bereichen 112 und 122 in einer gemeinsamen Schicht.

Da der erste optisch aktive Bereich 112 und der zweite optisch aktive Bereich 122 tatsächlich jedoch in der ersten Schicht 110 beziehungsweise in der zweiten Schicht 120 angeordnet sind, kann deren Aufbau und Funktion vereinfacht werden. Insbesondere ist eine einfachere Abführung von in dem ersten oder zweiten optisch Bereich 112 beziehungsweise 122 erzeugter Wärme möglich.

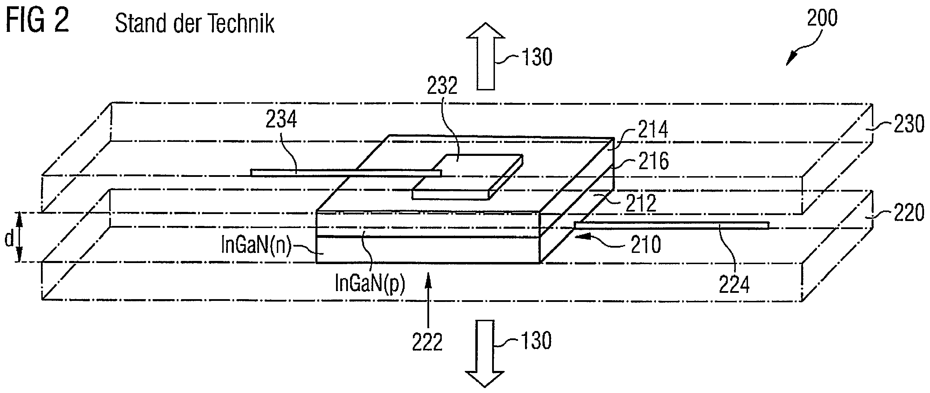

Figur 2 zeigt eine Anordnung 200 zur beidseitigen Abstrahlung elektromagnetischer Strahlung nach dem Stand der Technik. Die Anordnung 200 umfasst eine Diodenstruktur 210 sowie eine erste Trägerschicht 220 und eine zweite Trägerschicht 230.

Im dargestellten Ausführungsbeispiel ist die Diodenstruktur 210 zur beidseitigen Emission von elektromagnetischer Strahlung 130 ausgestaltet. Deshalb bestehen sowohl die erste Trägerschicht 220 als auch die zweite Trägerschicht 230 aus einem transparenten oder semitransparenten Material. Beispielsweise können transparente Folien oder ein transparentes Vergussmaterial zur Herstellung der ersten Trägerschicht 220 und der zweiten Trägerschicht 230 eingesetzt werden.

Die Diodenstruktur 210 umfasst einen ersten, negativ dotierten Bereich 212 und einen zweiten, positiv dotierten Bereich 214. An einer Grenzfläche zwischen dem ersten, n-dotierten Bereich 212 und dem zweiten, p-dotierten Bereich 214 entsteht ein np-Übergang 216. Fließt durch die Diodenstruktur 210 ein elektrischer Strom, rekombinieren an dem np-Übergang Majoritäts- und Minoritätsladungsträgern miteinander und senden elektromagnetische Strahlung 130 aus. Bei der elektromagnetischen Strahlung 130 kann es sich um Licht im Sichtbaren Bereich oder außerhalb des Sichtbaren Bereichs, also insbesondere auch ultraviolette oder infrarote Strahlung handeln.

Auf dem ersten, n-dotierten Bereich 212 ist ein erster Kontakt 222 angeordnet. Auf dem zweiten, p-dotierten Bereich ist ein zweiter Kontakt 232 angeordnet. Der erste Kontakt 222 und der zweite Kontakt 232 dienen zum Zuführen eines Betriebsstroms zu der Diodenstruktur 210. Dazu ist der erste Kontakt 222 mit einer ersten Leiterbahn 224 und der zweite Kontakt 232 mit einer zweiten Leiterbahn 234 verbunden. Die erste Leiterbahn 224 ist in oder auf der ersten Trägerschicht 220 angeordnet. Die zweite Leiterbahn 234 ist in oder unter der zweiten Trägerschicht 230 angeordnet. Beispielsweise kann es sich um Leiterbahnen 224 und 234 aus einem metallischen Material handeln.

Der erste, n-dotierte Bereich 212 und der zweite, p-dotierte Bereich 214 umfassen im Ausführungsbeispiel ein Halbleitermaterial, beispielsweise Indium-Gallium-Nitrid (InGaN). Da die in der Figur 2 dargestellte Diodenstruktur 210 kein zusätzliches Substrat aufweist, besitzt die Diodenstruktur 210 eine verhältnismäßig geringe Dicke d, beispielsweise im Bereich von 5-10 µm. Die geringe Schichtdicke d ermöglicht den Aufbau mehrschichtiger Halbleiterbauelemente 100 mit einem verhältnismäßig kompakten Schichtstapel.

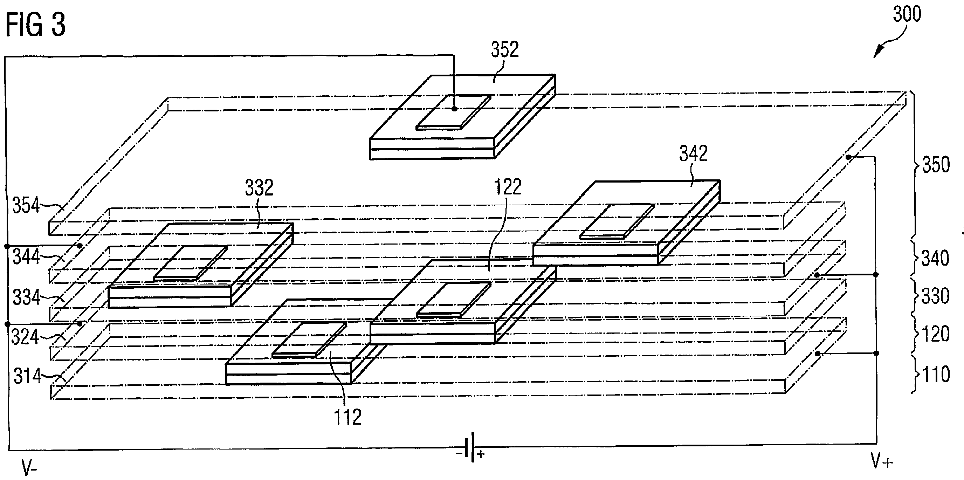

Figur 3 zeigt einen Schichtstapel 300. Der Schichtstapel 300 umfasst fünf Schichten 110, 120, 330, 340, 350. Jede der Schichten 110, 120, 330, 340 und 350 umfasst je einen optisch aktiven Bereich 112, 122, 332, 342 beziehungsweise 352. Jede der Schichten 110, 120, 330, 340 und 350 umfasst außerdem eine Zwischenschicht 314, 324, 334, 344 beziehungsweise 354, die jeweils unter dem optisch aktiven Bereich 112, 122, 332, 342 beziehungsweise 352 angeordnet ist.

Jeder der optisch aktiven Bereiche 112, 122, 332, 342 und 352 wird durch eine Diodenstruktur 210 gebildet, wie sie beispielsweise in der Figur 2 dargestellt ist. Durch abwechselndes Anlegen einer positiven und einer negativen Spannung V₊ beziehungsweise V₋ an die Zwischenschichten 314, 324, 334, 344 und 354 wird jeder der Diodenstrukturen 210 eine Betriebsspannung zugeführt.

Beispielsweise kann es sich bei den Zwischenschichten 314, 324, 334, 344, 354 um Schichten aus einem metallischen Material handeln. Dabei können in den Zwischenschichten in der Figur 3 nicht dargestellte Durchlassbereiche angeordnet sein, um die elektromagnetische Strahlung 130 von darüber beziehungsweise darunter angeordneten Halbleiterdiodenstrukturen 210 durchzulassen. Gemäß einer nicht beanspruchten Alternative ist es auch möglich, ein transparentes oder semitransparentes Material für die Zwischenschichten 314, 324, 334, 344, 354 einzusetzen. Beispielsweise eignet sich hierfür Indium-Zinn-Oxid (ITO). Selbstverständlich können die Zwischenschichten 314, 324, 334, 344, 354 auch aus einem nicht leitenden transparenten Kunststoffmaterial aufgebaut sein, auf die verhältnismäßig dünne, Leiterbahnen zur Zuführung der Betriebsspannung aufgebracht sind. Solche Leiterbahnen können beispielsweise durch so genannte Laser-Direkt-Strukturierung (LDS) aufgebracht werden. Dabei werden die Leiterbahnen mittels eines Lasers direkt auf das Bauelement geschrieben, wobei durch das Laserlicht ein Metallkomplex in einem Kunststoffmaterial aktiviert wird.

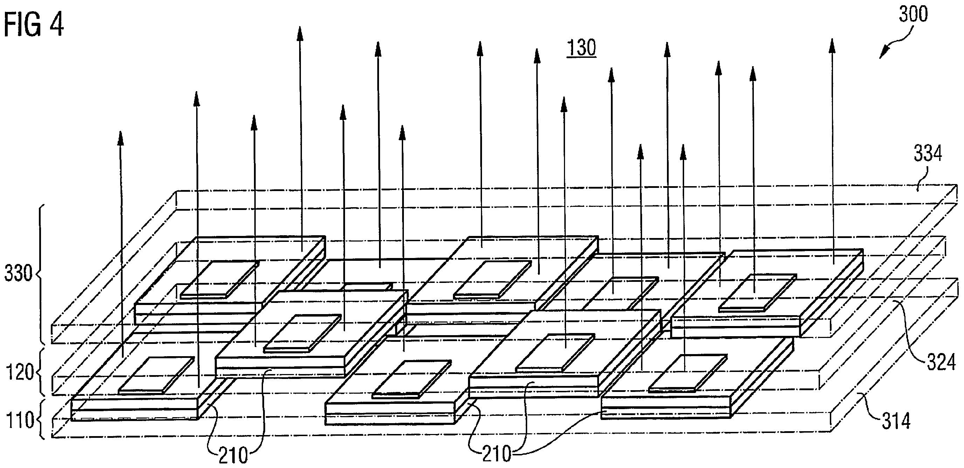

Figur 4 zeigt einen weiteren Schichtstapel 400 bei dem zehn Diodenstrukturen 210 in drei Schichten 110, 120 und 330 angeordnet sind. Jede der Schichten 110, 120 und 330 umfasst jeweils eine Zwischenschicht 314, 324 beziehungsweise 334. Die Diodenstrukturen 210 sind in dem Schichtstapel 400 gemäß Figur 4 räumlich neben- und hintereinander angeordnet. Auf diese Weise ergibt sich eine flächige Ausstrahlung von elektromagnetischer Strahlung 130 in der dargestellten Ausstrahlungsrichtung.

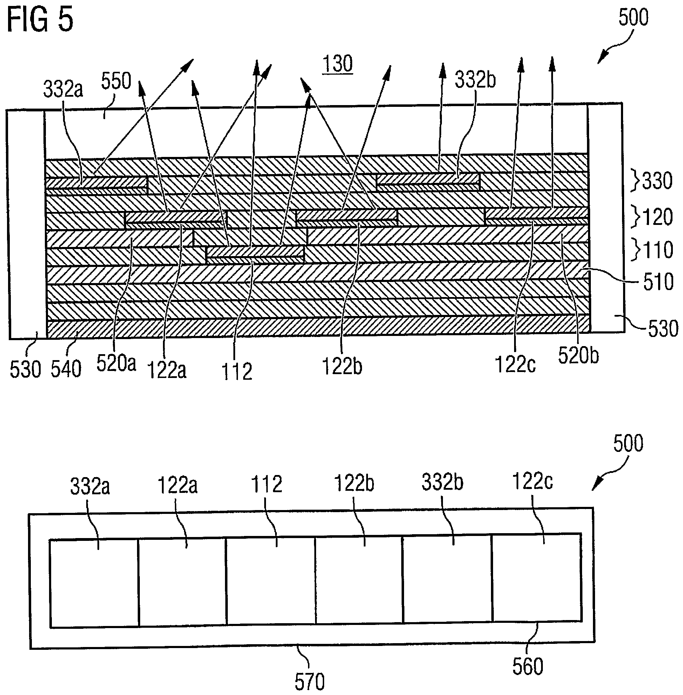

Figur 5 zeigt einen Querschnitt durch ein Halbleiterbauelement 500 gemäß einer weiteren Ausgestaltung der Erfindung. Figur 5 zeigt ebenfalls eine Draufsicht auf das Halbleiterbauelement 500.

Das Halbleiterbauelement 500 umfasst eine erste Schicht 110, eine zweite Schicht 120 und eine dritte Schicht 330. Die erste Schicht 110 umfasst einen ersten optisch aktiven Bereich 112. Die zweite Schicht 120 umfasst drei zweite optisch aktive Bereich 122a bis 122c. Die dritte Schicht 330 umfasst zwei dritte optisch aktive Bereich 332a und 332b. Bei den optisch aktiven Bereichen 112, 122, 332 kann es sich beispielsweise um Diodenstrukturen 210 gemäß Figur 2 handeln.

Das Halbleiterbauelement 500 umfasst zusätzlich zwei Kühlschichten 510 und 520, die zur Ableitung von Wärme dienen, die die optisch aktiven Bereiche 112 beziehungsweise 122 im Betrieb erzeugen. Die Kühlschicht 510 dient zur Ableitung der Wärme der optisch aktiven Schicht 112. Die zweigeteilte Kühlschicht 520a und 520b dient zur Ableitung der Wärme der optisch aktiven Bereich 122a beziehungsweise 122b und 122c.

Im Ausführungsbeispiel sind die Kühlschichten 510 und 520 thermisch mit einer Wärmesenke 530 verbunden. Die Wärmesenke 530 kann ein Gehäusekörper des Halbleiterbauelementes 500, ein zusätzlich an dem Halbleiterbauelement 500 angeordneter Kühlkörper oder eine sonstige geeignete Vorrichtung zur Ableitung oder Dissipation von Wärme sein.

Die Kühlschichten 510 und 520 können beispielsweise aus einem metallischen oder einem Keramikmaterial aufgebaut sein. Sowohl metallische als auch Keramikmaterialien eignen sich gut zur Leitung von Wärme. Im Falle eines metallischen Materials können die Kühlschichten 510 oder 520 zusätzlich zur Zuführung einer Betriebsspannung zu den optisch aktiven Bereichen 112 und 122 dienen.

In einer besonders leistungsfähigen Ausgestaltung des Halbleiterbauelementes 500 umfasst die Kühlschicht 510 oder die Kühlschicht 520 einen Hohlraum, der zumindest teilweise mit einer Kühlflüssigkeit aufgefüllt ist. Durch Konvektion der Kühlflüssigkeit in dem Hohlraum kann eine verbesserte Wärmeleitung bewirkt werden. In einer weiteren Ausgestaltung wird eine Kühlflüssigkeit aktiv durch einen Hohlraum einer Kühlschicht 510 oder 520 gepumpt.

Das Halbleiterbauelement 500 umfasst des Weiteren eine Reflexionsschicht 540. Bei der Reflexionsschicht 540 kann es sich beispielsweise um eine von unten auf das Halbleiterbauelement 500 aufgedampfte Metallschicht handeln, die die elektromagnetische Strahlung 130 der optisch aktiven Elemente 112, 122, 332 reflektiert. Auf diese Weise wird elektromagnetische Strahlung 130, die von den optisch aktiven Bereichen 112, 122, 332 in die der Ausstrahlungsrichtung entgegen gesetzte Richtung ausgestrahlt wird, reflektiert.

Schließlich umfasst das Halbleiterbauelement 500 eine Konversionsschicht 550. Die Konversionsschicht 550 wandelt eine von einem der optisch aktiven Bereiche 112, 122, 332 ausgestrahlte elektromagnetische Strahlung wenigstens einer ersten Wellenlänge λ₁ in eine elektromagnetische Strahlung wenigstens einer zweiten Wellenlänge λ₂ um. Beispielsweise ist es möglich, von einer Diodenstruktur 210 ausgesandtes blaues Licht durch eine geeignete Konversionsschicht 550 in weißes Licht umzuwandeln, wobei Teile der elektromagnetischen Strahlung 130 transmittiert und andere Teile der elektromagnetischen Strahlung absorbiert und mit größerer Wellenlänge erneut aus der Konversionsschicht 550 emittiert werden.

Anstelle oder zusätzlich zur Konversionsschicht können auch andere optische Elemente, wie beispielsweise Linsen, Prismen oder mikrostrukturierte Oberflächen, auf dem Schichtstapel angeordnet werden, um den Strahlengang des Halbleiterbauelementes 500 in gewünschter Weise an ein gegebenes Anforderungsprofil anzupassen. Es ist auch möglich, das Gehäuse des Halbleiterbauelementes 500 selbst transparent auszugestalten, so dass es selbst als optisches Element wirkt.

Des Weiteren können an dem Gehäuse ein oder mehrere Kontakte zum Anschluss des Halbleiterbauelementes 500 vorgesehen sein. Sind der oder die Kontakte an der Unterseite des Gehäuses, also gegenüber der Abstrahlrichtung angeordnet, kann das Halbleiterbauelement 500 in so genannter Oberflächemontagetechnik (surface mount technology - SMT) befestigt werden. Bei Verwendung eines metallischen Gehäuses kann das Gehäuse selbst als Anschlusskontakt, insbesondere Massekontakt, dienen.

Figur 5 zeigt ebenfalls eine Draufsicht auf das Halbleiterbauelement 500. In ihr ist zu erkennen, dass, aus Richtung der vorbestimmten Ausstrahlungsrichtung betrachtet, die in den unterschiedlichen Schichten 110, 120, 330 angeordneten optisch aktiven Bereich 112, 122, 332 eine homogen leuchtende Fläche 560 ergeben. Die leuchtende Fläche 560 ist durch einen Gehäusekörper 570 an ihren Rändern begrenzt. Der Gehäusekörper 570 kann auch partiell mit transparenten Auskoppelstrukturen versehen sein, um eine Auskopplung der elektromagnetischen Strahlung nur in eine bestimmte Raumrichtung zu bewirken.

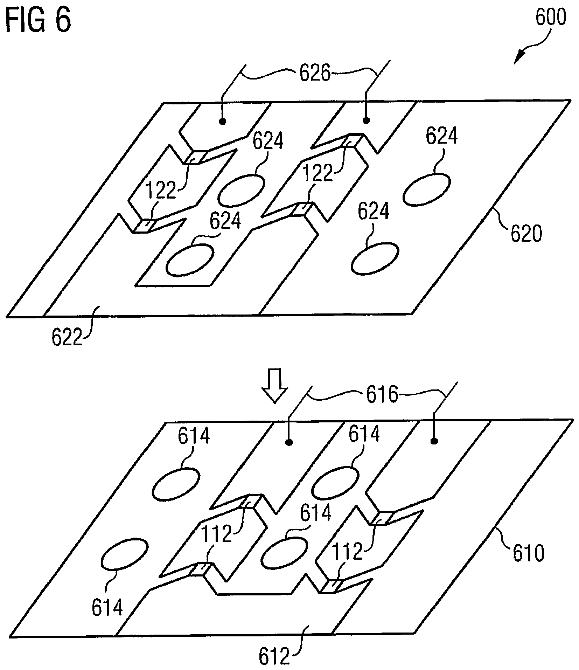

Figur 6 zeigt eine erste Kunststofffolie 610 und eine zweite Kunststofffolie 620. Auf der ersten Kunststofffolie 610 und der zweiten Kunststofffolie 620 ist eine Metallbeschichtung 612 beziehungsweise 622 angeordnet. In den Metallbeschichtungen 612 und 622 sowie den Kunststofffolien 610 und 620 sind durchgehende Löcher 614 und 624 in einer regelmäßigen Rasterstruktur angeordnet. Ebenfalls sind erste und zweite optisch aktive Bereiche 112 und 122 auf der ersten Kunststofffolie 610 beziehungsweise der zweiten Kunststofffolie 624 angeordnet. Die optisch aktiven Elemente 112 und 122 sind ebenfalls in einer regelmäßigen Rasterstruktur angeordnet, deren Gitterweite mit der Gitterweite der Löcher 614 beziehungsweise 624 übereinstimmt.

Durch Übereinanderanordnung der ersten Kunststofffolie 610 und der zweiten Kunststofffolie 620 wird ein Bauelement 600 hergestellt, das über eine scheinbar doppelt so dichte Anordnung von optisch aktiven Elementen 112 und 122 verfügt wie jede der Kunststofffolien 610 und 620 für sich allein genommen. Dazu wird die zweite Kunststofffolie 620 derart über der ersten Kunststofffolie 610 angeordnet, dass die optisch aktiven Elemente 112 der ersten Kunststofffolie 610 durch die Löcher 624 der zweiten Kunststofffolie 620 hindurch scheinen. Beide Kunststofffolien 610 und 620 werden über elektrische Zuleitungen 616 beziehungsweise 626 mit einer Betriebsspannung versorgt. Dabei wird die Betriebsspannung über die Metallbeschichtungen 612 und 622 den einzelnen optisch aktiven Elementen 112 beziehungsweise 122 zugeführt. Die einzelnen optisch aktiven Elemente 112 und 122 sowie die Kunststofffolien 610 und 620 können dabei entweder in Serie oder auch parallel geschaltet werden.

Wenn die optisch aktiven Elemente 112 und 122 zur doppelseitigen Abstrahlung eingerichtet sind, wie dies beispielsweise bei der Diodenstruktur 210 der Fall ist, strahlt das Bauelement 600 elektromagnetische Strahlung 130 in zwei einander gegenüberliegende Raumrichtungen ab. Darüber hinaus eignet sich die Ausgestaltung gemäß Figur 6 für biegbare Halbleiterbauelemente 600, wenn entsprechend flexible Kunststofffolien 610 und 620 gewählt werden.

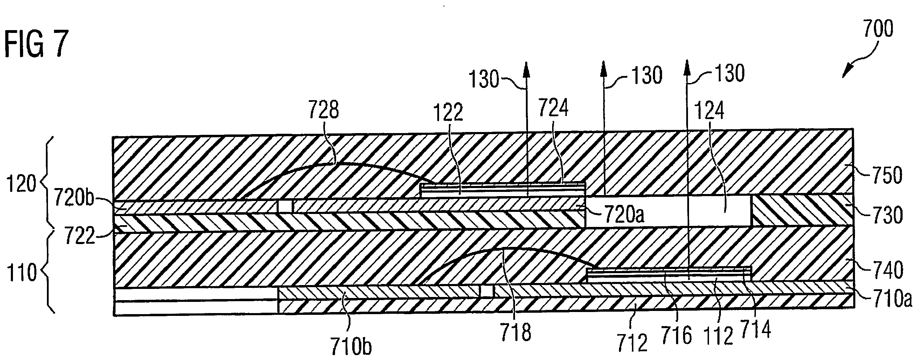

Figur 7 zeigt ein Halbleiterbauelement 700 gemäß einer weiteren Ausgestaltung der Erfindung. Das Halbleiterbauelement 700 umfasst eine erste Schicht 110 und eine zweite Schicht 120.

Die erste Schicht 110 weist einen ersten optisch aktiven Bereich 112 auf. Die zweite Schicht 120 weist einen zweiten optisch aktiven Bereich 122 auf. Des Weiteren weist die erste Schicht 110 zwei Metallfolien 710a und 710b zur Zu- beziehungsweise Abführung eines Betriebsstroms auf. Die Metallfolie 710 ist auf einer Kunststofffolie 712 angeordnet, die als Trägermaterial für die Metallfolie 710a und 710b sowie den ersten optisch aktiven Bereich 112 dient.

Der optisch aktive Bereich 112 umfasst beispielsweise einen Halbleiterchip 714 umfassend ein Substrat 716 und eine Diodenstruktur 210. In dem dargestellten Ausführungsbeispiel wird ein erster Kontakt zu der Diodenstruktur 210 über die Metallfolie 710a und das Substrat 716 hergestellt. Ein zweiter Kontakt wird über die zweite Metallfolie 710b mittels einer Kontaktierung 718 hergestellt. Bei der Kontaktierung 718 kann es sich beispielsweise um einen so genannten Bonddraht oder eine Kontaktfeder handeln.

Die zweite Schicht 120 ist ähnlich aufgebaut wie die erste Schicht 110. Insbesondere umfasst die Schicht 120 ebenfalls eine erste und eine zweite Metallfolie 720a und 720b, eine Kunststofffolie 722 und einen Halbleiterchip 724. Der Halbleiterchip 724 wird in äquivalenter Weise zu dem Halbleiterchip 714 über ein Substrat 726 beziehungsweise eine Kontaktierung 728 mit einer Betriebsspannung versorgt.

Zusätzlich verfügt die zweite Schicht 120 über einen Durchlassbereich 124, der räumlich über dem ersten optisch aktiven Bereich 112 angeordnet ist. In diesem Bereich umfasst die zweite Schicht 120 weder die Metallfolie 720 noch die Kunststofffolie 722, die die Ausstrahlung der elektromagnetischen Strahlung 130 des ersten optisch aktiven Bereiches 112 behindern würden. Schließlich umfasst die zweite Schicht 120 einen Abstandshalter 730, der einen Verguss 740 der ersten Schicht 110 von einem Verguss 750 der zweiten Schicht 120 trennt. Bei dem Verguss 740 beziehungsweise 750 handelt es sich beispielsweise um ein transparentes Kunststoffmaterial oder ein Kunststoffharz. In dem Verguss 740 oder 750 können auch Konversionsmaterialien eingearbeitet werden, die elektromagnetische Strahlung 130 der optisch aktiven Bereiche 112 beziehungsweise 122 in einer gewünschten Art und Weise konvertieren.

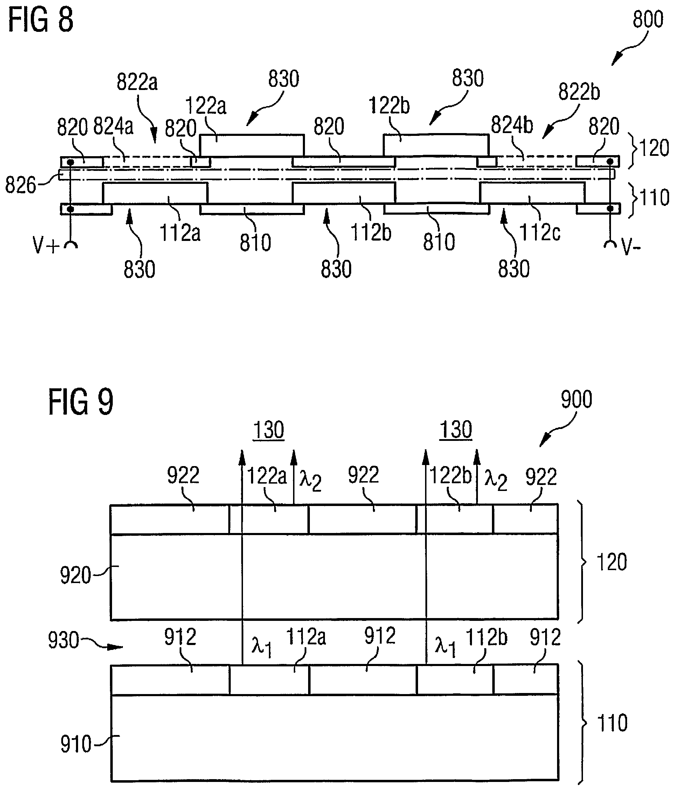

Figur 8 zeigt ein Halbleiterbauelement 800 gemäß einer weiteren Ausgestaltung der Erfindung. Das Halbleiterbauelement 800 umfasst eine erste Schicht 110 und eine zweite Schicht 120.

Die erste Schicht 110 umfasst drei optisch aktive Bereich 112a bis 112c. Die zweite Schicht 120 umfasst zwei optisch aktive Bereiche 122a, 122b. Jeder der optisch aktiven Bereiche 112 und 122 umfasst eine Halbleiterstruktur 830. Hierbei handelt es sich um Diodenstrukturen mit einer Schichtdicke von etwa 100 µm. Die Halbleiterstrukturen 830 gemäß dem Ausführungsbeispiel der Figur 8 werden in einem linken beziehungsweise einem rechten Bereich kontaktiert. Hierzu sind die optisch aktiven Bereiche 112a bis 112c auf einer unterbrochenen Metallschicht 810 angeordnet. Durch die unterbrochene Metallschicht 810 wird eine Serienschaltung der optisch aktiven Bereiche 112a, 112b und 112c hergestellt.

Die optisch aktiven Bereiche 122a und 122b sind auf einer transparenten Trägerschicht 826 angeordnet, die zumindest einen Teil der elektromagnetischen Strahlung 130 der optisch aktiven Bereiche 112a bis 112c transmittiert. Die Trägerschicht 826 umfasst eine zweite unterbrochene Metallschicht 820. Die Metallschicht 820 dient zur Kontaktierung der optisch aktiven Bereiche 122a und 122b.

Die unterbrochene Metallschicht 820 weist Aussparungen 822a und 822b auf, die als Durchlassbereiche 124a beziehungsweise 124b dienen. Die Aussparungen 822a und 822b sind durch Überbrückungen 824a beziehungsweise 824b elektrisch überbrückt. Bei den Überbrückungen kann es sich beispielsweise um Teile der unterbrochenen Metallschicht 824 selbst handeln, die räumlich vor oder hinter den Aussparungen 822 angeordnet sind. Alternativ können auch relativ dünne elektrische Kontaktierungen Verwendung finden, die den Austritt der elektromagnetischen Strahlung 130 nicht oder nur unwesentlich behindern. Dabei kann es sich beispielsweise um Bonddrähte oder um dünne, in einer zusätzlichen Schicht angeordnete Leiterbahnen handeln.

Figur 9 zeigt ein optisches Halbleiterbauelement 900 gemäß einer nicht beanspruchten Ausgestaltung. Das optische Halbleiterbauelement 900 umfasst eine erste Schicht 110 und eine zweite Schicht 120.

Die erste Schicht 110 und die zweite Schicht 120 umfassen jeweils eine transparente Trägerschicht 910 beziehungsweise 920 sowie eine elektrisch leitende Anschlussschicht 912 beziehungsweise 922. Die erste Schicht 110 umfasst zwei optisch aktive Bereiche 112a und 112b. Die zweite Schicht 120 umfasst zwei optisch aktive Bereiche 122a und 122b. Im in der Figur 9 dargestellten Ausführungsbeispiel sind die optisch aktiven Bereiche 112 und 122 in die elektrisch leitende Anschlussschicht 912 beziehungsweise 922 eingelassen. Beispielsweise kann es sich bei den Anschlussschichten 912 und 922 um ein Halbleitersubstrat handeln, in das durch geeignete Dotierung Anschlussbereiche und Diodenstrukturen eingebracht wurden.

Die optisch aktiven Bereich 122a und 122b sind in Richtung einer ausgestrahlten elektromagnetischen Strahlung 130 über den optisch aktiven Bereichen 112 beziehungsweise 112b angeordnet. Sie sind teilweise transparent ausgeführt und wirken so selber als Durchlassbereich 124 für die darunter liegende Bereiche 112a und 112b. Durch die in Abstrahlrichtung kongruente Anordnung der optisch aktiven Bereiche 112 und 122 kann eine elektromagnetische Strahlung 130a der ersten optisch aktiven Bereiche 112a und 112b mit einer elektromagnetischen Strahlung 130b der zweiten optisch aktiven Bereiche 122a und 122b gemischt werden. Beispielsweise ist es möglich, Licht einer ersten Wellenlänge λ₁ mit einer ersten Farbe, zum Beispiel grün, durch die optisch aktiven Bereiche 112a und 112b auszusenden. Die optisch aktiven Bereiche 122a und 122b können Licht einer zweiten Wellenlänge λ₂ mit einer zweiten Farbe, zum Beispiel rot, aussenden. Durch gleichzeitige Aktivierung der optisch aktiven Bereiche 112a, 112b, 122a und 122b entsteht für einen Betrachter des Halbleiterbauelementes 900 der Eindruck, dass Licht einer dritten Farbe, zum Beispiel gelb, ausgestrahlt würde.

In der Figur 9 sind die erste Schicht und die zweite Schicht 120 beabstandet angeordnet. Werden die Schichten in einen geschlossenen Gehäusekörper integriert, kann ein Zwischenraum 930 mit einer Kühlflüssigkeit durchströmt werden, um besonders leistungsfähige optisch aktive Bereiche 112 und 122 zu kühlen. Bevorzugt wird eine Kühlflüssigkeit mit einer hohen spezifischen Wärmekapazität, wie etwa Wasser oder Alkohol, oder ein spezielles Kühlmittel, wie etwa eine Kohlenwasserstoffverbindung, eingesetzt.

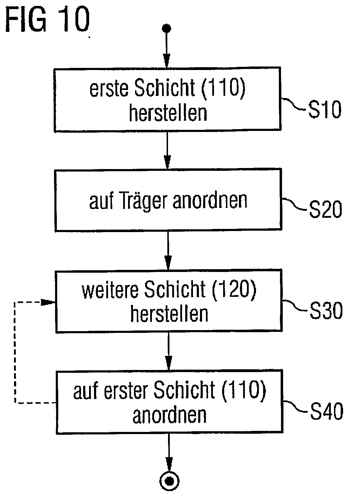

Figur 10 zeigt ein Ablaufdiagramm eines der Erläuterung dienenden Verfahrens zur Herstellung eines Halbleiterbauelementes.

In einem ersten Schritt S10 wird eine erste Schicht 110 mit einem ersten optisch aktiven Bereich 112 zum Abstrahlen von elektromagnetischer Strahlung 130 in wenigstens einer Abstrahlrichtung hergestellt. Beispielsweise kann eine Diodenstruktur 210 durch Dotierung eines Halbleitermaterials hergestellt werden.

In einem zweiten Schritt S20 wird die erste Schicht 110 in einem Gehäusekörper 570 oder auf einem Trägermaterial 140 angeordnet. Durch das Anordnen der ersten Schicht 110 auf einem Trägermaterial 140 oder in einem Gehäusekörper 570 können optional auch elektrische Anschlüsse oder eine thermische Verbindung zur Ableitung von in dem ersten Bereich 112 erzeugter Wärme hergestellt werden.

In einem weiteren Schritt S30 wird eine zweite Schicht 120 mit wenigstens einem optisch aktiven zweiten Bereich 122 zum Abstrahlen von elektromagnetischer Strahlung 130 hergestellt. In der zweiten Schicht 120 wird wenigstens ein erster Durchlassbereich 124 eingearbeitet. Der Durchlassbereich 124 kann beispielsweise durch Herstellen einer Aussparung oder durch Einbringen eines transparenten oder semitransparenten Materials in die zweite Schicht 120 hergestellt werden.

In einem weiteren Schritt S40 wird die zweite Schicht 120 auf der ersten Schicht 110 angeordnet, wobei der wenigstens eine Durchlassbereich 124 über dem wenigstens einen optisch aktiven Bereich 112 der ersten Schicht 110 angeordnet wird. Beispielsweise ist eine Ausrichtung anhand vorgegebener Rasterstrukturen möglich. Es ist auch möglich, die zweite Schicht direkt auf die erste Schicht aufzuwachsen, wobei dem Fachmann hierfür sämtliche bekannten lithographischen Verfahren zur Verfügung stehen.

Optional können die Schritte S30 und S40 für weitere Schichten 330, 340 oder 350 wiederholt werden, bis ein gewünschter Schichtstapel 300 oder 400 hergestellt ist.

Zusätzlich können optionale, weitere Schichten, etwa Kühlschichten 510 oder 520, Reflexionsschichten 540, Konversionsschichten 550 oder Anschlussschichten 912 oder 922, während der Herstellung in einen Schichtstapel 300 oder 400 eingearbeitet werden.

Die oben angegebene Abfolge von Schritten dient lediglich der Erläuterung des beschriebenen Herstellungsverfahrens. Prozessbedingt ist jedoch auch eine andere Reihenfolge der Schritte oder deren Parallelisierung möglich.

Ebenso können sämtliche in den einzelnen Ausführungsbeispielen offenbarte Merkmale in vielfältiger Weise miteinander kombiniert werden. Insbesondere ist die Erfindung nicht durch die Beschrei-j bung anhand der Ausführungsbeispiele auf diese beschränkt. Der Schutzbereich wird durch die Ansprüche definiert.

## Patentansprüche

1. Halbleiterbauelement aufweisend
- wenigstens einen optisch aktiven ersten Bereich (112) zum Abstrahlen von elektromagnetischer Strahlung (130) in wenigstens eine Abstrahlrichtung und
- wenigstens einen optisch aktiven zweiten Bereich (122) zum Abstrahlen von elektromagnetischer Strahlung (130) in die wenigstens eine Abstrahlrichtung, wobei
- der erste Bereich (112) in einer ersten Schicht (110) und der zweite Bereich (122) in einer zweiten Schicht (120) angeordnet ist, wobei die zweite Schicht (120) in der Abstrahlrichtung über der ersten Schicht (110) angeordnet ist und einen dem ersten Bereich (112) zugeordneten ersten Durchlassbereich (124) aufweist, der zumindest teilweise durchlässig für die elektromagnetische Strahlung (130) des ersten Bereichs ist (112),
wobei zwischen der ersten und der zweiten Schicht (110, 120) wenigstens eine Schicht aus einem metallischen Material angeordnet ist, die wenigstens eine Aussparung in einem dem ersten Bereich (112) zugeordneten zweiten Durchlassbereich aufweist, und
die zweite Schicht (120) in dem ersten Durchlassbereich (124) wenigstens eine Aussparung zum Durchlassen der elektromagnetischen Strahlung (130) der ersten Schicht (110) aufweist.

2. Halbleiterbauelement nach Anspruch 1,
**dadurch gekennzeichnet, dass**
die zweite Schicht (120) ein metallisches Material mit wenigstens einer Aussparung in dem ersten Durchlassbereich (124) umfasst.

3. Halbleiterbauelement nach Anspruch 1,
**dadurch gekennzeichnet, dass**
das metallische Material zur Ableitung von Wärme aus dem ersten Bereich (112) und/oder dem zweiten Bereich (122) eingerichtet ist.

4. Halbleiterbauelement nach einem der Ansprüche 1 bis 3,
**dadurch gekennzeichnet, dass**
der erste Durchlassbereich (124) und der zweite Bereich (122) räumlich benachbart sind und einen zusammenhängenden Abstrahlbereich bilden.

5. Halbleiterbauelement nach einem der Ansprüche 1 bis 4,
**dadurch gekennzeichnet, dass**
die wenigstens erste und zweite Schicht (110, 120) in einem gemeinsamen Gehäusekörper (570) angeordnet sind und der Gehäusekörper (570) ein optisches Element umfasst, das von dem ersten und/oder zweiten Bereich (112, 122) ausgestrahlte elektromagnetische Strahlung (130) in einer vorbestimmten Weise konvertiert, insbesondere durch Frequenzkonversion, Beugung, Brechung und/oder Filterung.

6. Halbleiterbauelement nach einem der Ansprüche 1 bis 5,
**dadurch gekennzeichnet, dass**
der erste und der zweite Bereich (112, 122) als Diodenstrukturen (210), ausgebildet sind, wobei es sich bei der ersten Schicht (110) und der zweiten Schicht (120) jeweils um ein Halbleitersubstrat handelt und die Diodenstrukturen (210) durch Dotierung des Halbleitermaterials des Halbleitersubstrats gebildet sind.

7. Halbleiterbauelement nach Anspruch 6,
**dadurch gekennzeichnet, dass**
der erste und/oder zweite Bereich (112, 122) dazu eingerichtet sind, elektromagnetische Strahlung (130) in die Abstrahlrichtung und eine dazu entgegengesetzte Richtung abzustrahlen.

8. Halbleiterbauelement nach einem der Ansprüche 1 bis 7,
**dadurch gekennzeichnet, dass**
zwischen der ersten und der zweiten Schicht (110, 120) wenigstens eine Kühlschicht (520) zum Abführen von Wärme des ersten und/oder zweiten Bereichs (112, 122) angeordnet ist, die wenigstens in einem dem ersten Bereich (112) zugeordneten zweiten Durchlassbereich teilweise transparent ausgebildet ist.

9. Halbleiterbauelement nach Anspruch 8,
**dadurch gekennzeichnet, dass**
die Kühlschicht einen wenigstens teilweise mit einer Kühlflüssigkeit gefüllten Hohlraum umfasst.

10. Halbleiterbauelement nach einem der Ansprüche 1 bis 9,
**dadurch gekennzeichnet, dass**
die erste und/oder zweite Schicht (110, 120) eine Mehrzahl von optisch aktiven Bereichen (112, 122) zum Abstrahlen von elektromagnetischer Strahlung (130) aufweist und jedem optisch aktiven Bereich (112) der ersten Schicht (110) ein erster Durchlassbereich (124) der zweiten Schicht (120) zugeordnet ist.

11. Halbleiterbauelement nach einem der Ansprüche 1 bis 10,
**dadurch gekennzeichnet, dass**
das Halbleiterbauelement eine Mehrzahl von übereinander angeordneten Schichten (110, 120, 330, 340, 350) mit jeweils wenigstens einem optisch aktiven Bereich (112, 122, 332, 342, 352) zum Abstrahlen von elektromagnetischer Strahlung (130) aufweist, wobei jede darüber liegende Schicht (120, 330, 340, 350) wenigstens einen Durchlassbereich (124) für elektromagnetische Strahlung (130) einer darunter liegenden Schicht (110, 120, 330, 340) aufweist.

## Claims

1. A semiconductor component comprising
- at least one optically active first region (112) for emitting electromagnetic radiation (130) in at least one emission direction, and
- at least one optically active second region (122) for emitting electromagnetic radiation (130) in the at least one emission direction, wherein
- the first region (112) is arranged in a first layer (110) and the second region (122) is arranged in a second layer (120), wherein the second layer (120) is arranged in the emission direction above the first layer (110) and has a first passage region (124) assigned to the first region (112), which is at least partially transmissive to the electromagnetic radiation (130) of the first region (112), wherein
between the first and second layers (110, 120) at least one layer of a metallic material is arranged, which comprises at least one cut-out in a second passage region assigned to the first region (112), and
the second layer (120) has at least one cut-out in the first passage region (124) to allow passage of the electromagnetic radiation (130) from the first layer (110).

2. A semiconductor component according to claim 1,
**characterised in that**
the second layer (120) comprises a metallic material with at least one cut-out in the first passage region (124).

3. A semiconductor component according to claim 1,
**characterised in that**
the metallic material is adapted to dissipate heat from the first region (112) and/or the second region (122).

4. A semiconductor component according to any one of claims 1 to 3,
**characterised in that**
the first passage region (124) and the second region (122) are spatially adjacent to one another and form a continuous emission region.

5. A semiconductor component according to any one of claims 1 to 4,
**characterised in that**
the at least first and second layers (110, 120) are arranged in a common housing body (570) and the housing body (570) comprises an optical element, which converts electromagnetic radiation (130) emitted by the first and/or second region (112, 122) in a predetermined manner, in particular by frequency conversion, diffraction, refraction and/or filtering.

6. A semiconductor component according to any one of claims 1 to 5,
**characterised in that**
the first and second regions (112, 122) are formed as diode structures (210), wherein the first layer (110) and the second layer (120) are each a semiconductor substrate and the diode structures (210) are formed by doping the semiconductor material of the semiconductor substrate.

7. A semiconductor component according to claim 6,
**characterised in that**
the first and/or second regions (112, 122) is/are operable to emit electromagnetic radiation (130) in the emission direction and a direction opposed thereto.

8. A semiconductor component according to any of claims 1 to 7, **characterized in that**
at least one cooling layer (520) is arranged between the first and second layers (110, 120) for dissipating heat from the first and/or second region (112, 122), which cooling layer is partially transparent at least in a second passage region assigned to the first region (112).

9. A semiconductor component according to claim 8,
**characterised in that**
the cooling layer comprises a cavity at least partially filled with a cooling liquid.

10. A semiconductor component according to any one of claims 1 to 9,
**characterised in that**
the first and/or second layer (110, 120) comprise(s) a plurality of optically active regions (112, 122) for emitting electromagnetic radiation (130) and a first passage region (124) of the second layer (120) is assigned to each optically active region (112) of the first layer (110).

11. A semiconductor component according to any one of claims 1 to 10,
**characterised in that**
the semiconductor component comprises a plurality of layers (110, 120, 330, 340, 350) arranged one above the other with in each case at least one optically active region (112, 122, 332, 342, 352) for emitting electromagnetic radiation (130), wherein each overlying layer (120, 330, 340, 350) comprises at least one passage region (124) for electromagnetic radiation (130) from an underlying layer (110, 120, 330, 340).

## Revendications

1. Composant semi-conducteur comprenant
- au moins une première zone optiquement active (112) pour l'émission d'un rayonnement électromagnétique (130) dans au moins une direction de rayonnement, et
- au moins une deuxième zone optiquement active (122) pour l'émission d'un rayonnement électromagnétique (130) dans ladite direction de rayonnement,
- la première zone (112) étant disposée dans une première couche (110) et la seconde zone (122) dans une seconde couche (120), la seconde couche (120) étant disposée dans la direction de rayonnement au-dessus de la première couche (110) et présentant une première bande passante (124) affectée à la première zone (112), qui est au moins partiellement perméable au rayonnement électromagnétique (130) de la première zone (112),
dans lequel
au moins une couche d'un matériau métallique, présentant au moins un évidement dans une deuxième bande passante affectée à la première zone (112), est disposée entre la première et la deuxième couche (110, 120), et
la deuxième couche (120) présente au moins un évidement dans la première bande passante (124) pour transmettre le rayonnement électromagnétique (130) de la première couche (110).

2. Composant semi-conducteur selon la revendication 1,
**caractérisé en ce que**
la deuxième couche (120) comprend un matériau métallique présentant au moins un évidement dans la première bande passante (124).

3. Composant semi-conducteur selon la revendication 1,
**caractérisé en ce que**
le matériau métallique est conçu pour dissiper la chaleur de la première zone (112) et/ou de la deuxième zone (122).

4. Composant semi-conducteur selon l'une des revendications 1 à 3,
**caractérisé en ce que**
la première bande passante (124) et la deuxième zone (122) sont spatialement adjacentes et forment une zone de rayonnement continue.

5. Composant semi-conducteur selon l'une des revendications 1 à 4,
**caractérisé en ce que**
au moins la première et la deuxième couche (110, 120) sont disposées dans un corps de boîtier commun (570) et le corps de boîtier (570) comprend un élément optique qui convertit le rayonnement électromagnétique (130) émis par la première et/ou la seconde zone (112, 122) d'une manière prédéterminée, notamment par conversion de fréquence, diffraction, réfraction et/ou filtrage.

6. Composant semi-conducteur selon l'une des revendications 1 à 5,
**caractérisé en ce que**
la première et la deuxième zone (112, 122) sont formées en tant que structures de diode (210), la première couche (110) et la deuxième couche (120) étant chacune un substrat semi-conducteur et les structures de diode (210) étant formées par dopage du matériau semi-conducteur du substrat semi-conducteur.

7. Composant semi-conducteur selon la revendication 6,
**caractérisé en ce que**
la première et/ou deuxième zone (112, 122) sont conçues pour émettre un rayonnement électromagnétique (130) dans la direction de rayonnement et dans une direction opposée à celle-ci.

8. Composant semi-conducteur selon l'une des revendications 1 à 7,
**caractérisé en ce que**
au moins une couche de refroidissement (520) visant à dissiper la chaleur de la première et/ou de la deuxième zone (112, 122) est disposée entre la première et la deuxième couche (110, 120), ladite couche de refroidissement étant partiellement transparente au moins dans une deuxième bande passante affectée à la première zone (112).

9. Composant semi-conducteur selon la revendication 8,
**caractérisé en ce que**
la couche de refroidissement comprend une cavité au moins partiellement remplie d'un liquide de refroidissement.

10. Composant semi-conducteur selon l'une des revendications 1 à 9,
**caractérisé en ce que**
la première et/ou la deuxième couche (110, 120) présente(nt) une pluralité de zones optiquement actives (112, 122) pour l'émission d'un rayonnement électromagnétique (130), et une première bande passante (124) de la seconde couche (120) est affectée à chaque zone optiquement active (112) de la première couche (110).

11. Composant semi-conducteur selon l'une des revendications 1 à 10,
**caractérisé en ce que**
le composant semi-conducteur comprend une pluralité de couches superposées (110, 120, 330, 340, 350) présentant chacune au moins une zone optiquement active (112, 122, 332, 342, 352) pour l'émission d'un rayonnement électromagnétique (130), chaque couche supérieure (120, 330, 340, 350) présentant au moins une bande passante (124) pour le rayonnement électromagnétique (130) d'une couche sous-jacente (110, 120, 330, 340).
